# EUROPEAN PATENT SPECIFICATION

(11) **EP 4 341 935 B1**
(45) Date of publication and mention of the grant of the patent: **25.06.2025**
(21) Application number: 21786653.2
(22) Date of filing: 02.09.2021
(51) Int. Cl.: G11C 16/30, G11C 16/08, G11C 16/16, G11C 5/02, G11C 5/14, G11C 8/08, G11C 11/54, G11C 16/04, G11C 29/12

(54) **NON-VOLATILE MEMORY CELL ARRAY FORMED IN A P-WELL IN A DEEP N-WELL IN A P-SUBSTRATE**
IN EINER P-WANNE IN EINER TIEFEN N-WANNE IN EINEM P-SUBSTRAT GEBILDETES NICHTFLÜCHTIGES SPEICHERZELLEN-ARRAY
MATRICE DE CELLULES DE MÉMOIRE NON VOLATILE FORMÉE DANS UN PUITS P DANS UN PUITS N PROFOND DANS UN SUBSTRAT P

(30) Priority: 18.05.2021 US 202163190200 P; 30.08.2021 US 202117461981
(43) Date of publication of application: 27.03.2024
(73) Proprietor: SILICON STORAGE TECHNOLOGY, INC., San Jose, CA 95134 (US)
(72) Inventor: TRAN, Hieu Van, San Jose, California 95135 (US); DO, Nhan, Saratoga, California 95070 (US)
(74) Representative: Betten & Resch
(86) International application number: PCT/US2021/048934
(87) International publication number: WO 2022/245383

(56) References cited:
- EP-A1- 1 002 320
- US-A- 5 998 826
- US-A1- 2006 044 872
- US-A1- 2007 280 001
- US-A1- 2011 096 609
- US-A1- 2015 200 018
- US-A1- 2017 098 474
- US-A1- 2019 115 088
- US-B1- 6 768 671

## Description

### PRIORITY CLAIM

This application claims priority to U.S. Provisional Patent Application No. 63/190,200, filed on May 18, 2021, and titled, "Non-Volatile Memory Cell Array with Substrate Capable of Receiving Negative Voltage During Erase Operations," and U.S. Patent Application No. 17/461,981 filed on August 30, 2021, and titled "Non-volatile Memory Cell Array Formed in a P-Well in a Deep N-Well in a P-Substrate".

### FIELD OF THE INVENTION

Numerous embodiments are disclosed for a non-volatile memory cell array formed in a p-well in a deep n-well in a p-substrate. During an erase operation, a negative voltage is applied to the p-well, which reduces the peak positive voltage required to erase the cells in the array.

US 6768671 B1 discribes that in an array of nonvolatile memory cells, as many memory cells as desired and indeed even the entire array of memory cells may be placed in a single region of the bulk, illustratively a p-well. Peripheral circuitry is used to in effect section the memory array into blocks and groups of blocks, and to establish suitable biasing and counter-biasing within those blocks and groups during page or block erase operations to limit erase disturb. Each group is provided with its own set of voltage switches, which furnishes the bias voltages for the various modes of operation, including erase. Each of the voltage switches furnish either a large positive voltage when its group is selected, or a large negative voltage when its group is unselected. The size of the group is established as a compromise between degree of erase disturb and substrate area required for the voltage switches.

US 20060044872 A1 describes NAND architecture Flash memory strings, memory arrays, and memory devices that utilize depletion mode floating gate memory cells. Depletion mode floating gate memory cells allegedly allow for increased cell current through lower channel rdS resistance and decreased "narrow width" effect, allegedly allowing for increased scaling of NAND memory cell strings.

US 20070028001 A1 describes a method for programming and erasing an array of NMOS electrically erasable programmable read only memory (EEPROM) cells. In addition, the array of N-channel memory cells may be separated into independently programmable memory segments by creating multiple, electrically isolated P-wells upon which the memory segments are fabricated. The multiple, electrically isolated P-wells may be created, for example, by p-n junction isolation or dielectric isolation.

US 20110096609 A1 describes that a nonvolatile memory array has nonvolatile memory cells arranged in rows and columns where each column has a bit line and source line associated with and in parallel with the nonvolatile memory cells. In programming the nonvolatile memory cell, approximately equal program voltage levels are applied to a drain and a source of a selected charge retaining transistor such that the difference in the voltage between the drain and the source of the selected charge retaining transistor is less than a drain to source breakdown voltage of the selected charge retaining transistor to prevent drain-to-source punch through. In programming or erasing the nonvolatile memory cell a control gate and a bulk program voltage level is applied to a control gate and bulk such that the magnitude of the control gate and bulk program voltage levels is less than a breakdown voltage level of peripheral circuitry.

US 20190115088 A1 describes that during a program, read, or erase operation of one or more non-volatile flash memory cells in an array of non-volatile flash memory cells, a negative voltage can be applied to the word lines and/or coupling gates of the selected or unselected non-volatile flash memory cells. The negative voltage is generated by a negative high voltage level shifter using one of several embodiments disclosed herein.

EP 1002320 A1 describes that the negative supply voltage (317) and isolation well bias (320) used by the wordline drivers (306) during erase are decoded separately from the decoding of the inputs of the individual wordline drivers. The wordline drivers selectively drive wordlines with a wordline voltage from either a first supply voltage source or a second supply voltage source in response to address signals which identify the respective drivers. The second supply voltage source includes a set of supply voltage selectors (302, 319). Each supply voltage selector in the set is coupled with a subset of the set of drivers.

### BACKGROUND OF THE INVENTION

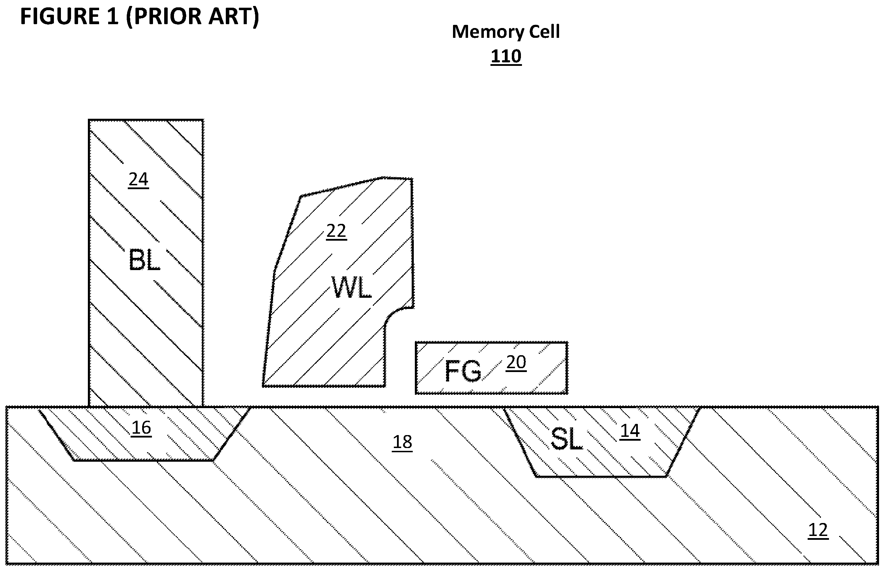

Different types of non-volatile memories are well known. For example, U.S. Patent 5,029,130 ("the "130 patent"), discloses an array of split gate non-volatile memory cells, which are a type of flash memory cells. Such a memory cell 110 is shown in Figure 1. Each memory cell 110 includes source region 14 and drain region 16 formed in semiconductor substrate 12, with channel region 18 there between. Floating gate 20 is formed over and insulated from (and controls the conductivity of) a first portion of channel region 18, and over a portion of source region 14. Word line terminal 22 (which is typically coupled to a word line) has a first portion that is disposed over and insulated from (and controls the conductivity of) a second portion of channel region 18, and a second portion that extends up and over the floating gate 20. Floating gate 20 and word line terminal 22 are insulated from substrate 12 by a gate oxide. Bitline 24 is coupled to drain region 16.

Memory cell 110 is erased (where electrons are removed from the floating gate) by placing a high positive voltage (with respect to substrate 12) on word line terminal 22, which causes electrons on floating gate 20 to tunnel through the intermediate insulation from floating gate 20 to word line terminal 22 via Fowler-Nordheim (FN) tunneling.

Memory cell 110 is programmed by source side injection (SSI) with hot electrons (where electrons are placed on the floating gate) by placing a positive voltage (with respect to substrate 12) on word line terminal 22, and a positive voltage on source region 14. Electron current will flow from drain region 16 towards source region 14. The electrons will accelerate and become heated when they reach the gap between word line terminal 22 and floating gate 20. Some of the heated electrons will be injected through the gate oxide onto the floating gate 20 due to the attractive electrostatic force from floating gate 20.

Memory cell 110 is read by placing positive read voltages (with respect to substrate 12) on drain region 16 and word line terminal 22 (which turns on the portion of the channel region 18 under the word line terminal). If floating gate 20 is positively charged (i.e. erased of electrons), then the portion of channel region 18 under floating gate 20 is turned on as well, and current will flow across channel region 18, which is sensed as the erased or "1" state. If floating gate 20 is negatively charged (i.e., programmed with electrons), then the portion of the channel region 18 under floating gate 20 is mostly or entirely turned off, and current will not flow (or there will be little flow) across channel region 18, which is sensed as the programmed or "0" state.

Table No. 1 depicts typical voltage and current ranges that can be applied to the terminals of memory cell 110 for performing read, erase, and program operations:

**Table No. 1: Operation of Flash Memory Cell 110 of Figure 1**

| | WL | BL | SL |
|---|---|---|---|
| Read | 2-3V | 0.6-2V | 0V |
| Erase | ~11-13V | 0V | 0V |
| Program | 1-2V | 10.5-3µA | 9-10V |

The voltages of Table No. 1 are with reference to substrate 12, to which 0V is applied during a read, erase, or program operation.

Other split gate memory cell configurations, which are other types of flash memory cells, are known.

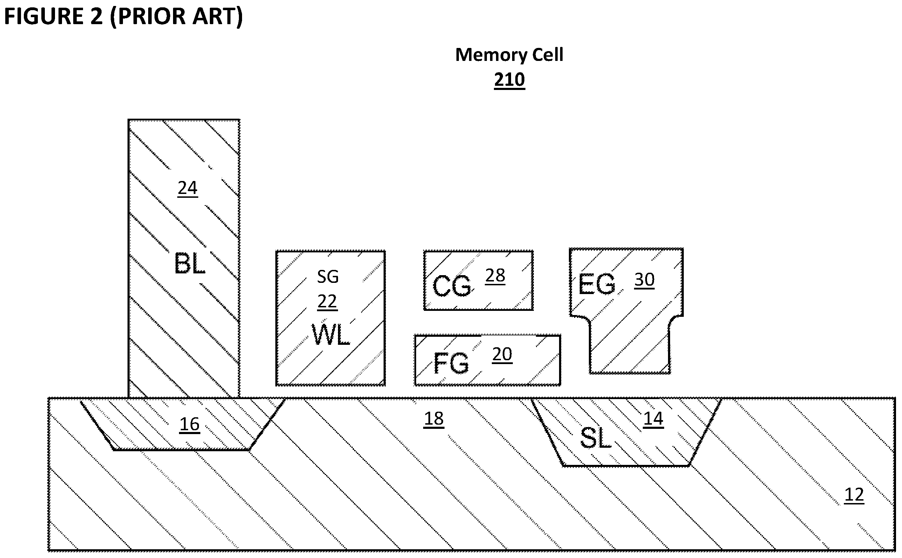

For example, Figure 2 depicts a four-gate memory cell 210 comprising source region 14, drain region 16, floating gate 20 over a first portion of channel region 18, select gate 22 (typically coupled to a word line, WL) over a second portion of the channel region 18, control gate 28 over the floating gate 20, and erase gate 30 over the source region 14. This configuration is described in U.S. Patent 6,747,310. Here, all gates are non-floating gates except floating gate 20, meaning that they are electrically connected or connectable to a voltage source. Programming is performed by heated electrons from the channel region 18 injected through the gate oxide onto floating gate 20 due to the attractive electrostatic force from the floating gate 20. Erasing is performed by electrons tunneling from floating gate 20 to erase gate 30.

Table No. 2 depicts typical voltage and current ranges that can be applied to the terminals of memory cell 210 for performing read, erase, and program operations:

**Table No. 2: Operation of Flash Memory Cell 210 of Figure 2**

| | WL/SG | BL | CG | EG | SL |
|---|---|---|---|---|---|
| Read | 1.0-2V | 0.6-2V | 0-2.6V | 0-2.6V | 0V |
| Erase | -0.5V/0V | 0V | 0V/-8V | 8-12V | 0V |
| Program | 1V | 0.1-1µA | 8-11V | 4.5-9V | 4.5-5V |

A voltage of 0V is be applied to substrate 12 during a read, erase, or program operation.

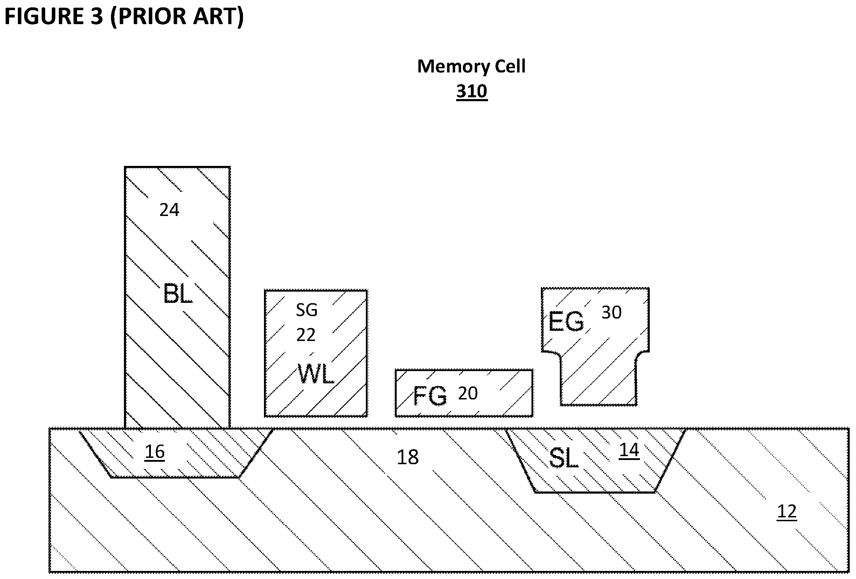

Figure 3 depicts a three-gate memory cell 310, which is another type of flash memory cell. Memory cell 310 is identical to memory cell 210 of Figure 2 except that memory cell 310 does not have a separate control gate. The erase operation (whereby erasing occurs through use of the erase gate) and read operation are similar to that of memory cell 210 of Figure 2 except that no control gate bias applied. The programming operation also is done without the control gate bias, and as a result, a higher voltage must be applied on the source line during a program operation to compensate for a lack of control gate bias.

Table No. 3 depicts typical voltage and current ranges that can be applied to the terminals of memory cell 310 for performing read, erase, and program operations:

**Table No. 3: Operation of Flash Memory Cell 310 of Figure 3**

| | WL/SG | BL | EG | SL |
|---|---|---|---|---|
| Read | 0.7-2.2V | 0.6-2V | 0-2.6V | 0V |
| Erase | -0.5V/0V | 0V | 11.5V | 0V |
| Program | 1V | 0.2-3µA | 4.5V | 7-9V |

A voltage of 0V is applied to substrate 12 during a read, erase, or program operation.

Space within a semiconductor die is precious. In the prior art systems described above, substantial space is required for circuits external to the array that are necessary for read, program, and/or erase operations. For example, the high voltages required for erase operations require special high voltage generation and regulation circuitry, which in turns requires high voltage transistors that require large areas on the semiconductor die due to thicker gate oxide, longer channel length, and wider physical spacing.

What is needed is a new architecture for an array of non-volatile memory cells that reduces the voltage required for erase operations, which would then reduce the space required for high voltage generation and regulation circuitry.

### SUMMARY OF THE INVENTION

The invention relates to a non-volatile memory system according to independent claim 1. Further preferred embodiments are defined in the dependent claims.

### BRIEF DESCRIPTION OF THE DRAWINGS

Figure 1 depicts a prior art split gate flash memory cell.
Figure 2 depicts another prior art split gate flash memory cell.
Figure 3 depicts another prior art split gate flash memory cell.
Figure 4 depicts a non-volatile memory system.
Figure 5 depicts a non-volatile memory system comprising a p-well surrounding the array.
Figure 6 depicts a non-volatile memory system comprising p-wells surrounding an array, low voltage decoder circuitry, and high voltage decoder circuitry.
Figure 7 depicts a non-volatile memory system comprising p-wells surrounding a first array, a second array, low voltage decoder circuitry, and high voltage decoder circuitry in accordance with the invention.
Figure 8 depicts a non-volatile memory system comprising p-wells surrounding a first array, a second array, first low voltage decoder circuitry, second low voltage decoder circuitry, first high voltage decoder circuitry, and second high voltage decoder circuitry in accordance with the invention.
Figure 9 depicts a cross-section of a non-volatile memory system comprising a p-well surrounding an array.

### DETAILED DESCRIPTION OF THE INVENTION

The embodiments described herein enable a negative-voltage to be applied to a p-well surrounding certain components to enable a lower voltage to be used during erase operations of non-volatile memory cells.

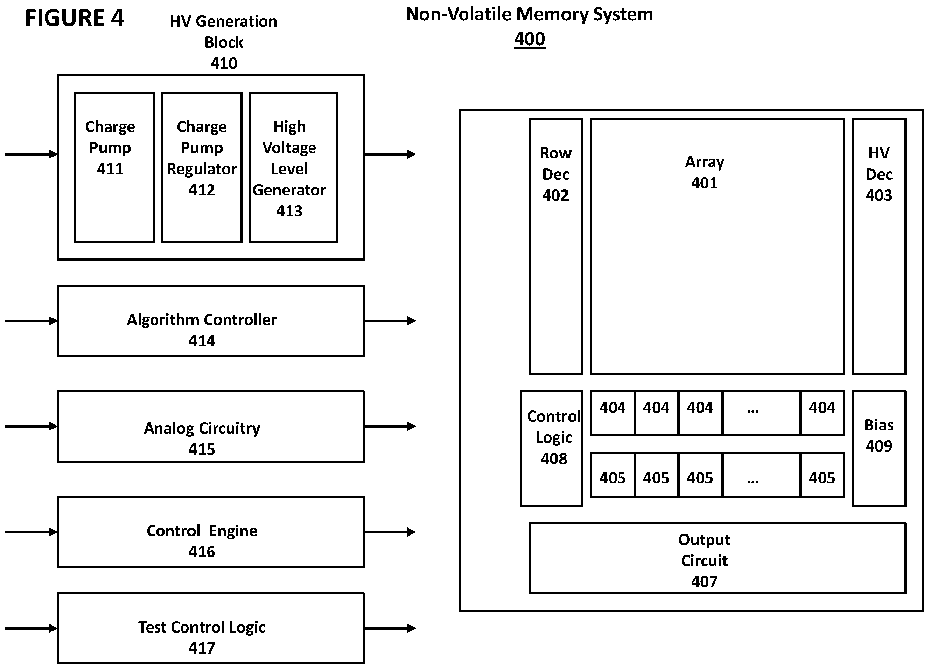

Figure 4 depicts a block diagram of non-volatile memory system 400. Non-volatile memory system 400 comprises array 401, row decoder 402, high voltage decoder 403, column decoders 404, bit line drivers (also known as column drivers) 405 (for controlling program (current) on bitline terminals), output circuit 407, control logic 408, and bias generator 409. Non-volatile memory system 400 further comprises high voltage generation block 410, which comprises charge pump 411, charge pump regulator 412, and high voltage level generator 413. Non-volatile memory system 400 further comprises (program/erase, or weight tuning) algorithm controller 414, analog circuitry 415, control engine 416 (that may include special functions such as arithmetic functions, activation functions, or embedded microcontroller logic, without limitation), and test control logic 417.

Output circuit 407 may include circuits such as digital sensing circuitry to convert cell current into a logic '1' or '0', or analog sensing circuitry such as a ADC (analog to digital converter) to convert neuron analog output to digital bits), AAC (analog to analog converter) such as a current to voltage converter, logarithmic converter, APC (analog to pulse(s) converter), analog to time modulated pulse converter, or any other type of converters. The output circuit 407 may implement an activation function such as a rectified linear activation function (ReLU) or sigmoids. Output circuit 407 may implement statistic normalization, regularization, up/down scaling/gain functions, statistical rounding, or arithmetic functions (e.g., add, subtract, divide, multiply, shift, log) for neuron outputs. Output circuit 407 may implement a temperature compensation function for bitline outputs.

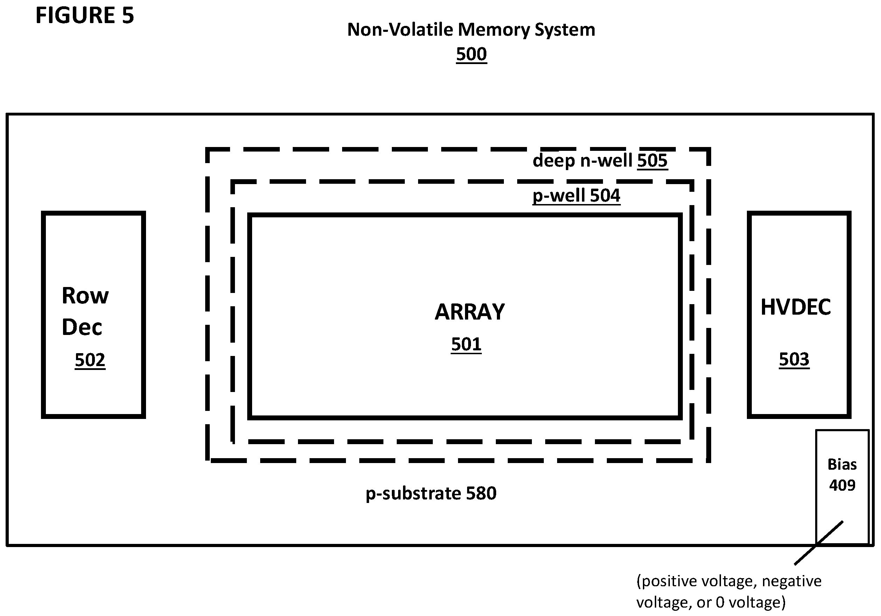

In the embodiments described below with reference to Figures 5-9, the array, and optionally other components, are placed within a p-well surrounded by, and on top of, a deep n-well. A negative voltage, in relation to p-substrate, is then be applied to the p-well, by bias generator 409 or another voltage source, during certain operations such as erase operations of non-volatile memory cells. This reduces the maximum voltage required for the erase operation, thereby reducing the overall size and power of the high voltage generation block 410

Figure 5 depicts a top view of non-volatile memory system 500. Non-volatile memory system 500 comprises array 501, row decoder 502 (an example of row decoder 402 in Figure 4), and high voltage decoder 503 (an example of high voltage decoder 403 in Figure 4). Array 501 is formed within p-well 504, which is formed within deep n-well 505, and deep n-well 505 is formed within p-substrate 580. P-well 504 hence can receive a different voltage (including but not limited to a negative voltage) due to its isolation from p-substrate 580 by deep n-well 505. For example, p-substrate 580 can be biased at 0V, deep n-well 505 can be biased at 0-2V, and p-well 504 can be biased at -0.1V to - 10V. These bias voltages can be generated by bias generator 409 or another voltage source.

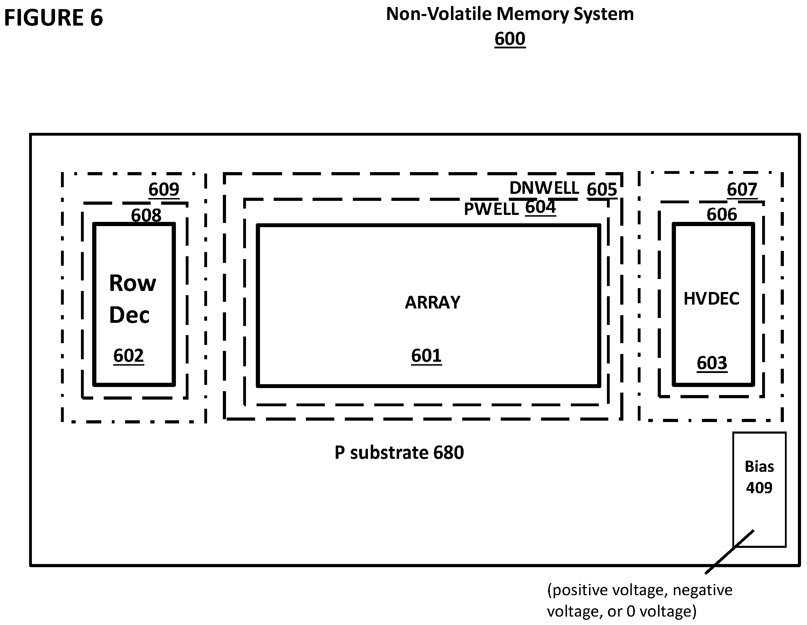

Figure 6 depicts non-volatile memory system 600. Non-volatile memory system 600 comprises array 601, row decoder 602 (an example of row decoder 402 in Figure 4), and high voltage decoder 603 (an example of high voltage decoder 403 in Figure 4).

Array 601 is formed within p-well 604, and p-well 604 is formed within deep n-well 605.

Row decoder 602 is formed within p-well 608, which p-well 608 is formed within deep n-well 609.

High voltage decoder 603 is formed within p-well 606, and p-well 606 is formed within deep n-well 607.

Deep n-wells 605, 607, and 609 are respectively formed within (and on top of) p-substrate 680. Optionally, deep n-wells 605, 607, and 609 can be separate deep n-wells or part of a common deep n-well.

P-well 604 containing array 601 hence can be driven with a negative voltage, in relation to p-substrate 680, by bias generator 409 or another voltage source due to its isolation from p-substrate 680 by deep n-well 605.

P-well 606 containing high voltage decoder 603 hence can be driven with a negative voltage, in relation to p-substrate 680, by bias generator 409 or another voltage source due to its isolation from p-substrate 680 by deep n-well 607.

For example, p-substrate 680 can be biased at 0V, deep n-wells 605, 707, and 609 can be biased at 0-3V, and p-wells 604, 606, and 608 can be biased at -0.1V to -10V. These bias voltages can be generated by bias generator 409 or another voltage source.

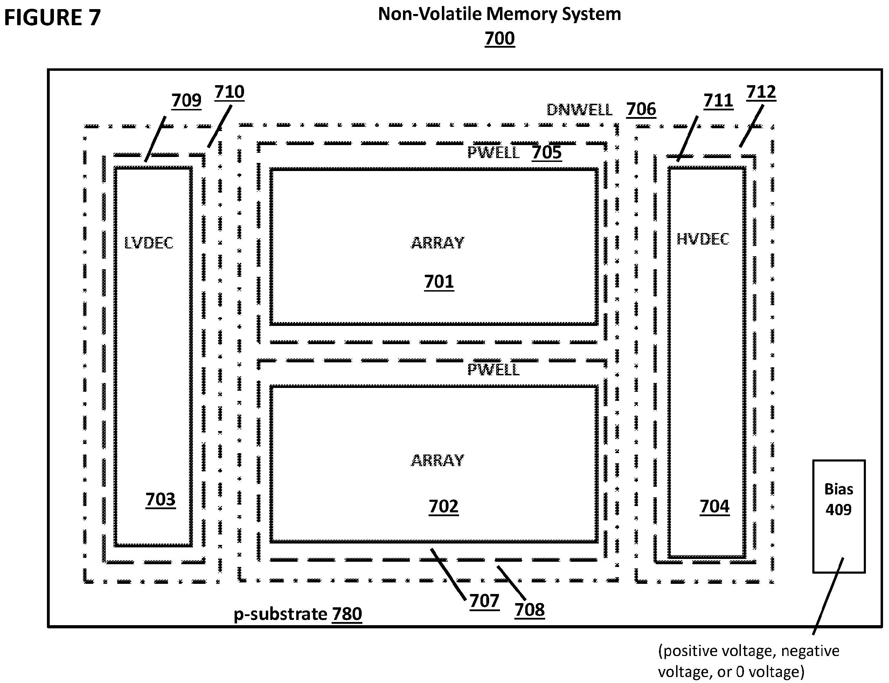

Figure 7 depicts non-volatile memory system 700 according to the invention. Non-volatile memory system 700 comprises array 701, array 702, low voltage decoder 703, and high voltage decoder 704. Array 701 is formed within p-well 705, and p-well 705 is formed within deep n-well 706. Array 702 is formed within p-well 707, and p-well 707 is formed within deep n-well 708. Low voltage decoder 703 is formed within p-well 709, and p-well 709 is formed within deep n-well 710. High voltage decoder 704 is formed within p-well 711, and p-well 711 is formed within deep n-well 712. Optionally, deep n-wells 706, 708, 710, and 712 can be separate deep n-wells or part of a common deep n-well. The p substrate PSUB 780 is the substrate that all circuits, i.e., array 701, array 702, low voltage decoder 703, and high voltage decoder 704, are formed upon.

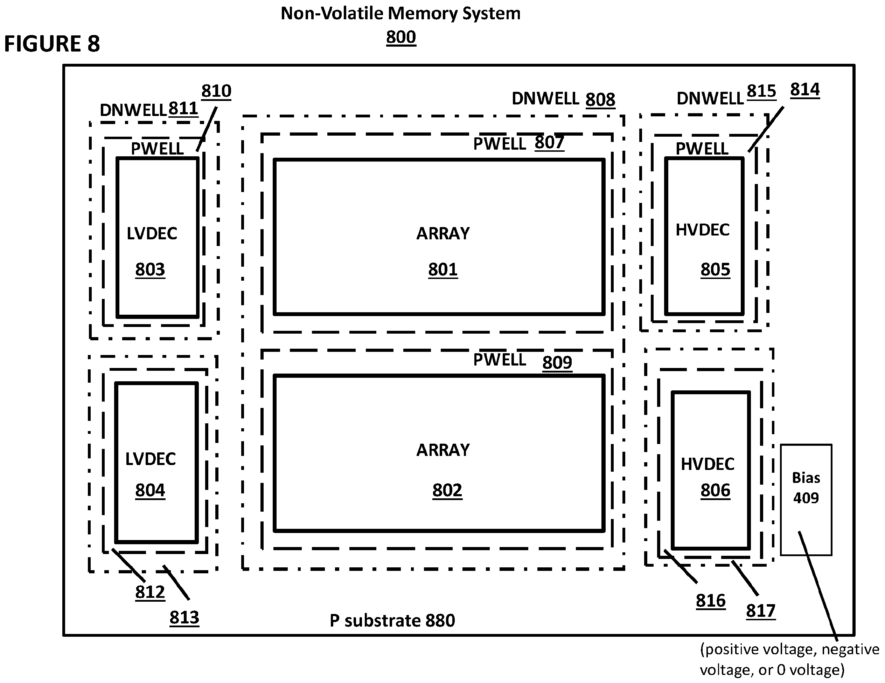

Figure 8 depicts non-volatile memory system 800 according to the invention. Non-volatile memory system 800 comprises array 801, array 802, low voltage decoder 803, low voltage decoder 804, high voltage decoder 805, and high voltage decoder 806. Array 801 is formed within p-well 807, and p-well 807is formed within deep n-well 808. Array 802 is formed within p-well 809, and p-well 809 is also formed within deep n-well 808. Low voltage decoder 803 is formed within p-well 810, and p-well 810 is formed within deep n-well 811. Low voltage decoder 804 is formed within p-well 812, and p-well 812is formed within deep n-well 813. High voltage decoder 805 is formed within p-well 814, and p-well 814is formed within deep n-well 815. High voltage decoder 806 is formed within p-well 816, and p-well 816 is formed within deep n-well 817. Optionally, deep n-wells 808, 811, 815, 813, and 817 can be separate deep n-wells or part of a common deep n-well. P-substrate 880 is the substrate that all circuits, i.e., array 801, array 802, low voltage decoder 803, low voltage decoder 804, high voltage decoder 805, and high voltage decoder 806, are formed upon.

P-well 807 or 809 hence can go be driven to a negative voltage, in respect to p-substrate 880, independently, by bias generator 409 or another voltage source, due to its isolation from p-substrate 880 by deep n-well 808. Similarly, p-wells 810, 812, 814, 816 hence can be driven to a negative voltage independently, in respect to p-substrate 880, by bias generator 409 or another voltage source, due to their isolation from p-substrate 880 by respective deep n-wells 811, 813, 815, and 817.

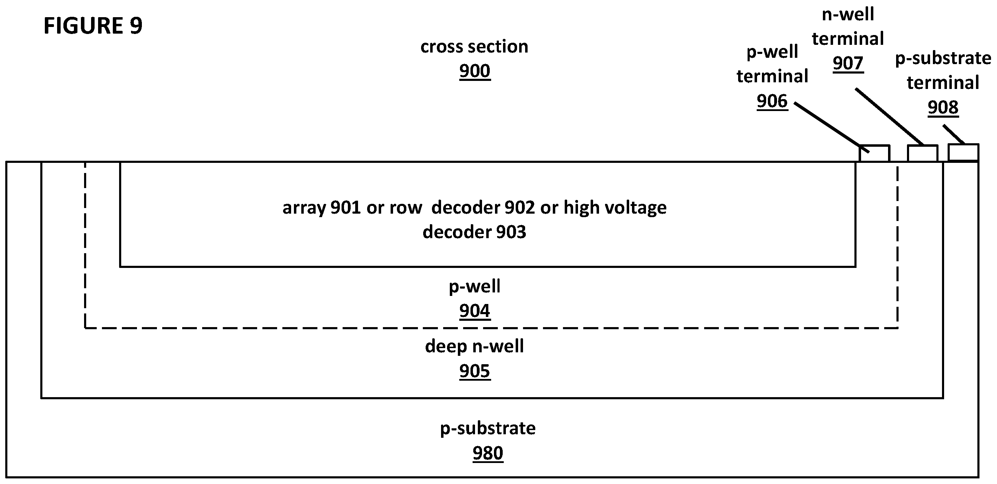

Figure 9 depicts cross-section 900. Array 901 or low voltage decoder, row decoder 902, or high voltage decoder 903 (which are representative of the arrays, row decoders, and high voltage decoders, respectively, depicted in Figures 5-8) is formed within p-well 904, p-well 904 is formed within deep n-well 905, and deep n-well 905 is formed within p-substrate 980. P-well terminal 906 provides access to p-well 904 and can be used, for example, to apply a negative voltage (in relation to p-substrate 980) to p-well 904 by bias generator 409 or another voltage source during an erase operation. N-well terminal 907 is used to apply a bias voltage to deep n-well 905, and p-substrate terminal 908 is used to apply a bias voltage (which can include 0V) to p-substrate 980. P- substrate 980 is the substrate that all circuits, i.e., array 901 or low voltage decoder, row decoder 902, or high voltage decoder 903, are formed upon.

Optionally, p-substrate 980 in Figures 5-9 can be biased by bias generator 409 or another voltage source at a negative voltage such as - 0.1V to -3V instead of 0V.

Using the architectures of Figures 5-9, the following operating voltages can be used to perform read, program, and erase operations on non-volatile memory cells 110, 210, and 310 of Figures 1-3, with the understanding that substrate 12 (which is a p-substrate) in Figures 1-3 is modified to include a p-well within a deep n-well, such as shown in cross-section 900 of Figure 9, where substrate 12 then becomes p-substrate 980, deep n-well 905 is formed within substrate 12, and p-well 904 is formed within deep n-well 905, where arrays of memory cells 110, 210, and 310 are formed within p-well 904. In addition, p-well 904 is accessed using p-well-terminal 906, deep n-well 905 is accessed using n-well terminal 907, and p-substrate 980 is accessed using p-substrate 980 as in Figure 9. In this configuration, p-well 904 acts as a (virtual) p-substrate for the memory cells of the array and for the other components.

Table Nos. 4-10 that follow contain exemplary operating voltages to be applied to memory cells 110, 210, and 310 when configured as in Figure 9. In these examples, a voltage of 0V is applied to p-substrate 980 (substrate 12) through p-substrate terminal 908, a voltage of 0-2V is applied to deep n-well 905 through n-well terminal 907, and a voltage of -0.1V to -12V is applied to p-well 904 through p-well terminal 906 by bias generator 409 or another voltage source.

Table No. 4 depicts a first set of operating voltages (defined with respect to substrate 12) for memory cell 110 of Figure 1 when the substrate 12 is modified to include p-well 904 within deep n-well 905 within substrate 12:

**Table No. 4: Operation of Memory Cell 110 of Figure 1**

| | **WL** | **BL** | **SL** | **P-Well 904** |
|---|---|---|---|---|
| **Selected Cell:** | | | | |
| Program | 1.5 V | 1-3 µA | 8-9 V | 0 V |
| Read | 2.5 V | 0.6-1.0 V | 0 V | 0 V |
| Erase (Using Positive Voltages) | 12.5 V | FLT | FLT | 0 V |
| Erase (Using a combination of Positive and Negative Voltages) | 10.5 V | FLT/-2.5 V | FLT/-2.5 V | -2.5 V |

| **Un-Selected Cell:** | | | | |
|---|---|---|---|---|
| Program | 0 V | Vdp/VINH | 8-9 V / 0.5 V | 0 V |
| Read | 0 V | 0.6-1.0 V | 0 V | 0 V |
| Erase (Using Positive Voltages) | 0 V | FLT | 0 V | 0 V |
| Erase (Using a Combination of Positive and Negative Voltages) | 0 V | FLTY/-2.5 V | FLT/ -2.5 V | -2.5 V |

Table No. 5 depicts a second set of operating voltages for memory cell 110 of Figure 1 when the substrate includes a p-well within a deep n-well:

**Table No. 5: Operation of Memory Cell 110 of Figure 1**

| | **WL** | **BL** | **SL** | **P-Well 904** |
|---|---|---|---|---|
| **Selected Cell:** | | | | |
| Program | 1.5 V | 1-3 µA | 8-9 V | 0 V |
| Read | 2.5 V | 0.6-1.0 V | 0 V | 0 V |
| Erase (Using Positive Voltages) | 12.5 V | FLT | FLT | 0 V |
| Erase (Using a Combination of Positive and Negative Voltages) | 8 V | FLT/-4.5 V | FLT/-4.5 V | -4.5 V |

| **Un-Selected Cell:** | | | | |
|---|---|---|---|---|
| Program | 0 V | Vdp/VINH | 8-9 V / 0.5 V | 0 V |
| Read | 0 V | 0.6-1.0 V | 0 V | 0 V |
| Erase (Using Positive Voltages) | 0 V | FLT | 0 V | 0 V |
| Erase (Using a Combination of Positive and Negative Voltages) | -2.5 V | FLTY/-4.5 V | FLT/ -4.5 V | -4.5 V |

P-well 904 is particularly advantageous in a situation where a negative voltage is applied to one or more terminals of the cell during an erase operation, because in that situation, applying a negative voltage to p-well 904 using bias generator 409 or another voltage source will reduce stress on the gate oxide regions when the negative voltage is applied to the terminal, as p-well 904 will serve as a virtual substrate for the cell that is biased to a negative voltage.

Table No. 4 is appropriate if stress on gate oxide regions is not a concern, while Table No. 5 is appropriate if stress on gate oxide regions is a concern. In Table No. 4, a word line voltage of 0V is applied to un-selected cells during an erase operation, while in Table No. 5, a word line voltage of -2.5V is applied to unselected cells during an erase operation, due to the fact that it is desired to reduce stress on the gate oxide regions of memory cell 110 as well as the peripheral (decoding) transistor for the 2.5V gate oxide. In the operation of Table No. 4, stress on the gate oxide regions of the decoding circuits is not a concern because the absolute voltage required will not cause the voltage across a gate oxide region to exceed the gate oxide break down voltage for both the decoding circuitry and the cells, and as a result, an isolated p-sub well 04 is not needed for the decoding circuitry. By contrast, in the implementation of Table 5, bias generator 409 or another voltage source applies negative voltages to certain terminals to reduce stress on the gate oxide regions, and as a result, an isolated p-sub well 904 is advantageous for the decoding circuitry.

Table No. 6 depicts a first set of operating voltages for memory cell 210 of Figure 2 when the substrate includes a p-well within a deep n-well:

**Table No. 6: Operation of Memory Cell 210 of Figure 2**

| | **WL** | **BL** | **SL** | **CG** | **EG** | **P-Well 904** |
|---|---|---|---|---|---|---|
| **Selected Cell:** | | | | | | |
| Program | 0.7 V | 1 µA | 4.5 V | 10 V | 4.5 V | 0 V |
| Read | 1.8 V | 0.6-1.0 V | 0 V | 1.8 V | 0-1.8 V | 0 V |
| Erase | 0 V | FLT/-2 V | FLT/-2 V | 0 V | 10.5 V | -2 V |

| **Un-Selected Cell:** | | | | | | |
|---|---|---|---|---|---|---|
| Program | 0 V | Vdp/VINH | 4.5/0.5 V | 0/2.5 V | 4.5/0 V | 0 V |
| Read | 0 V | 0.6-1.0 V | 0 V | 1.8 V | 0-2.5 V | 0 V |
| Erase | 0 V | FLT/-2 V | FLT/-2 V | 0 V | 0 V | -2 V |

Table No. 7 depicts a second set of operating voltages for memory cell 210 of Figure 2 when the substrate includes a p-well within a deep n-well:

**Table No. 7: Operation of Memory Cell 210 of Figure 2**

| | **WL** | **BL** | **SL** | **CG** | **EG** | **P-Well 904** |
|---|---|---|---|---|---|---|
| **Selected Cell:** | | | | | | |
| Program | 0.7 V | 1 µA | 4.5 V | 8-10 V | 4.5-8 V | 0 V |
| Read | 1.8 V | 0.6-1.0 V | 0 V | 1.8 V | 0-1.8 V | 0 V |
| Erase | 0 V | FLT/-4 V | FLT/-4 V | -6 V | 6 V | -4 V |

| **Un-Selected Cell**: | | | | | | |
|---|---|---|---|---|---|---|
| Program | 0 V | Vdp/VINH | 4.5/0.5 V | 0/2.5 V | 4.5-8/0 V | 0 V |
| Read | 0 V | 0.6-1.0 V | 0 V | 2.5 V | 0-2.5 V | 0 V |
| Erase | -2 V | FLT/-4 V | FLT/-4 V | 0 V | 0 V | -4 V |

Table No. 8 depicts a first set of operating voltages for memory cell 310 of Figure 3 when the substrate includes a p-well within a deep n-well:

**Table No. 8: Operation of Memory Cell 310 of Figure 3**

| | **WL** | **BL** | **SL** | **EG** | **P-Well 904** |
|---|---|---|---|---|---|
| **Selected Cell:** | | | | | |
| Program | 1.5 V | 1-3 µA | 8-9 V | 4-9 V | 0 V |
| Read | 2.5 V | 0.6-1.0 V | 0 V | 0-2.5 V | 0 V |
| Erase | -2.5 V | FLT/-4.5 V | FLT/-4.5V | 8.5 V | -4.5 V |

| **Un-Selected Cell:** | | | | | |
|---|---|---|---|---|---|
| Program | 0 V | Vdp/VINH | 8-9 V / 0.5 V | 4-9 V/0 V | 0 V |
| Read | 0 V | 0.6-1.0 V | 0 V | 0-2.5 V | 0 V |
| Erase | -2.5 V | FLT/-4.5 V | FLT/-4.5 V | -2.5V | -4.5 V |

For the same reasons discussed above with respect to Table Nos. 5 and 6, the use of p-well 904 would be particularly advantageous for Table No. 8 and to a greater extent than for Table No. 7.

Table No. 9 depicts a second set of operating voltages for memory cell 310 of Figure 3 when the substrate includes a p-well within a deep n-well:

**Table No. 9: Operation of Memory Cell 310 of Figure 3**

| | **WL** | **BL** | **SL** | **EG** | **P-Well 904** |
|---|---|---|---|---|---|
| **Selected Cell:** | | | | | |
| Program | 1.5 V | 1-3 µA | 8-9 V | 4-9 V | 0 V |
| Read | 2.5 V | 0.6-1.0 V | 0 V | 0-2.5 V | 0 V |
| Erase | 0 V | FLT/-2.5 V | FLT/-2.5V | 10.5 V | -2.5 V |

| **Un-Selected Cell:** | | | | | |
|---|---|---|---|---|---|
| Program | 0 V | Vdp/VINH | 8-9 V / 0.5 V | 4-9 V/0 V | 0 V |
| Read | 0 V | 0.6-1.0 V | 0 V | 0-2.5 V | 0 V |
| Erase | 0 V | FLT/-2.5 V | FLT/-2.5 V | 0V | -2.5 V |

**Table No. 10: Operation of Memory Cell 310 of Figure 3**

| | W**L** | **BL** | **SL** | **EG** | **P-Well 904** |
|---|---|---|---|---|---|
| **Selected Cell:** | | | | | |
| Program | 1.5 V | 1-3 µA | 8-9 V | 4-9 V | 0 V |
| Read | 2.5 V | 0.6-1.0 V | 0 V | 0-2.5 V | 0 V |
| Erase | -2.5 V | FLT/-2.5 V | FLT/-2.5V | 8.5 V | -4.5 V |

| **Un-Selected Cell:** | | | | | |
|---|---|---|---|---|---|
| Program | 0 V | Vdp/VINH | 8-9 V / 0.5 V | 4-9 V/0 V | 0 V |
| Read | 0 V | 0.6-1.0 V | 0 V | 0-2.5 V | 0 V |
| Erase | -2.5 V | FLT/-2.5 V | FLT/-2.5 V | -2.5V | -4.5 V |

For the same reasons discussed above with respect to Table Nos. 5 and 6, the use of p-well 904 would be particularly advantageous for Table No. 10 and to a greater extent than for Table No. 9.

It should be noted that, as used herein, the terms "over" and "on" both inclusively include "directly on" (no intermediate materials, elements or space disposed therebetween) and "indirectly on" (intermediate materials, elements or space disposed therebetween). Likewise, the term "adjacent" includes "directly adjacent" (no intermediate materials, elements or space disposed therebetween) and "indirectly adjacent" (intermediate materials, elements or space disposed there between), "mounted to" includes "directly mounted to" (no intermediate materials, elements or space disposed there between) and "indirectly mounted to" (intermediate materials, elements or spaced disposed there between), and "electrically coupled" includes "directly electrically coupled to" (no intermediate materials or elements there between that electrically connect the elements together) and "indirectly electrically coupled to" (intermediate materials or elements there between that electrically connect the elements together). For example, forming an element "over a substrate" can include forming the element directly on the substrate with no intermediate materials/elements therebetween, as well as forming the element indirectly on the substrate with one or more intermediate materials/elements there between.

## Claims

1. A non-volatile memory system (800), comprising:
a deep n-well (808) formed in a p-substrate (880) in a semiconductor die;
a first p-well (807) formed within the deep n-well;
a second p-well (809) formed within the deep n-well;
a first array (801) of non-volatile split-gate flash memory cells formed within the first p-well, each non-volatile split-gate flash memory cell in the first array comprising a floating gate and a plurality of terminals;
a second array (802) of non-volatile split gate flash memory cells formed within the second p-well, each non-volatile split-gate flash memory cell in the second array comprising a floating gate and a plurality of terminals;
a bias generator (409) to apply a negative voltage to the first p-well during an erase operation of one or more of the non-volatile split-gate flash memory cells in the first array and to apply independently a negative voltage to the second p-well during an erase operation of one or more of the non-volatile split-gate flash memory cells in the second array;
a low voltage decoder (803, 804) formed within a third p-well (810, 812) formed within a second deep n-well (811, 813); and
a high voltage decoder circuit (805, 806) formed within a fourth p-well (814, 816) formed within a third deep n-well (815, 817).

2. The non-volatile memory system of claim 1, wherein the plurality of terminals for each non-volatile split-gate flash memory cell in the first array and the second array comprises a bit line terminal, a source line terminal, and a word line terminal.

3. The non-volatile memory system of claim 2, wherein the plurality of terminals for each non-volatile split-gate flash memory cell in the first array and the second array further comprises an erase gate terminal.

4. The non-volatile memory system of claim 3, wherein the plurality of terminals for each non-volatile split-gate flash memory cell in the first array and the second array further comprises a control gate terminal.

5. The non-volatile memory system of claim 1, wherein the bias generator is to apply a voltage of 0 V to word lines of un-selected non-volatile split-gate flash memory cells (210, 310) during read, erase, and programming operations.

6. The non-volatile memory system of claim 1, wherein the bias generator is to apply a negative voltage to a control gate terminal of a selected
split-gate flash memory cell during an erase operation.

## Patentansprüche

1. Nichtflüchtiges Speichersystem (800), umfassend:
eine tiefe n-Wanne (808), die in einem p-Substrat (880) in einem Halbleiterchip gebildet ist;
eine erste p-Wanne (807), die innerhalb der tiefen n-Wanne gebildet ist;
eine zweite p-Wanne (809), die innerhalb der tiefen n-Wanne gebildet ist;
ein erstes Array (801) aus nichtflüchtigen Split-Gate-Flash-Speicherzellen, die innerhalb der ersten p-Wanne gebildet sind, wobei jede nichtflüchtige Split-Gate-Flash-Speicherzelle im ersten Array ein Floating Gate und eine Vielzahl von Anschlüssen umfasst;
ein zweites Array (802) aus nichtflüchtigen Split-Gate-Flash-Speicherzellen, das innerhalb der zweiten p-Wanne gebildet ist, wobei jede nichtflüchtige Split-Gate-Flash-Speicherzelle im zweiten Array ein Floating Gate und eine Vielzahl von Anschlüssen umfasst;
einen Vorspannungsgenerator (409) zum Anlegen einer negativen Spannung an die erste p-Wanne während eines Löschvorgangs einer oder mehrerer der nichtflüchtigen Split-Gate-Flash-Speicherzellen im ersten Array und zum unabhängigen Anlegen einer negativen Spannung an die zweite p-Wanne während eines Löschvorgangs einer oder mehrerer der nichtflüchtigen Split-Gate-Flash-Speicherzellen im zweiten Array;
einen Niederspannungsdecoder (803, 804), der innerhalb einer dritten p-Wanne (810, 812) gebildet ist, die innerhalb einer zweiten tiefen n-Wanne (811, 813) gebildet ist; und
eine Hochspannungs-Dekodiererschaltung (805, 806), die innerhalb einer vierten p-Wanne (814, 816) gebildet ist, die innerhalb einer dritten tiefen n-Wanne (815, 817) gebildet ist.

2. Nichtflüchtiges Speichersystem nach Anspruch 1, wobei die Vielzahl von Anschlüssen für jede nichtflüchtige Split-Gate-Flash-Speicherzelle im ersten Array und im zweiten Array einen Bit-Leitungsanschluss, einen Source-Leitungsanschluss und einen Wort-Leitungsanschluss umfasst.

3. Nichtflüchtiges Speichersystem nach Anspruch 2, wobei die Vielzahl von Anschlüssen für jede nichtflüchtige Split-Gate-Flash-Speicherzelle im ersten Array und im zweiten Array ferner einen Löschgate-Anschluss umfasst.

4. Nichtflüchtiges Speichersystem nach Anspruch 3, wobei die Vielzahl von Anschlüssen für jede nichtflüchtige Split-Gate-Flash-Speicherzelle im ersten Array und im zweiten Array ferner einen Steuergate-Anschluss umfasst.

5. Nichtflüchtiges Speichersystem nach Anspruch 1, wobei der Vorspannungsgenerator eine Spannung von 0 V zu Wort-Leitungen von nicht ausgewählten, nichtflüchtigen Split-Gate-Flash-Speicherzellen (210, 310) während Lese-, Lösch- und Programmiervorgängen anlegen soll.

6. Nichtflüchtiges Speichersystem nach Anspruch 1, wobei der Vorspannungsgenerator während eines Löschvorgangs eine negative Spannung an einen Steuergate-Anschluss einer ausgewählten Split-Gate-Flash-Speicherzelle anlegen soll.

## Revendications

1. Système de mémoire non volatile (800), comprenant :
un puits n profond (808) formé dans un substrat p (880) dans une puce semi-conductrice ;
un premier puits p (807) formé à l'intérieur du puits n profond ;
un deuxième puits p (809) formé à l'intérieur du puits n profond ;
une première matrice (801) de cellules de mémoire flash non volatiles à grille divisée formées à l'intérieur du premier puits p, chaque cellule de mémoire flash non volatile à grille divisée dans la première matrice comprenant une grille flottante et une pluralité de bornes ;
une seconde matrice (802) de cellules de mémoire flash non volatiles à grille divisée formées à l'intérieur du deuxième puits p, chaque cellule de mémoire flash non volatile à grille divisée de la seconde matrice comprenant une grille flottante et une pluralité de bornes ;
un générateur de polarisation (409) pour appliquer une tension négative au premier puits p pendant une opération d'effacement d'une ou de plusieurs cellules de mémoire flash non volatile à grille divisée de la première matrice et pour appliquer indépendamment une tension négative au deuxième puits p pendant une opération d'effacement d'une ou de plusieurs cellules de mémoire flash non volatile à grille divisée de la seconde matrice ;
un décodeur basse tension (803, 804) formé à l'intérieur d'un troisième puits p (810, 812) formé à l'intérieur d'un deuxième puits n profond (811, 813) ; et
un circuit décodeur haute tension (805, 806) formé à l'intérieur d'un quatrième puits p (814, 816) formé à l'intérieur d'un troisième puits n profond (815, 817).

2. Système de mémoire non volatile selon la revendication 1, dans lequel la pluralité de bornes pour chaque cellule de mémoire flash non volatile à grille divisée dans la première matrice et la seconde matrice comprend une borne de ligne de bit, une borne de ligne de source et une borne de ligne de mot.

3. Système de mémoire non volatile selon la revendication 2, dans lequel la pluralité de bornes pour chaque cellule de mémoire flash non volatile à grille divisée dans la première matrice et la seconde matrice comprend en outre une borne de grille d'effacement.

4. Système de mémoire non volatile selon la revendication 3, dans lequel la pluralité de bornes pour chaque cellule de mémoire flash non volatile à grille divisée dans la première matrice et la seconde matrice comprend en outre une borne de grille de commande.

5. Système de mémoire non volatile selon la revendication 1, dans lequel le générateur de polarisation doit appliquer une tension de 0 V aux lignes de mots des cellules de mémoire flash non volatile à grille divisée non sélectionnées (210, 310) pendant les opérations de lecture, d'effacement et de programmation.

6. Système de mémoire non volatile selon la revendication 1, dans lequel le générateur de polarisation doit appliquer une tension négative à une borne de grille de commande d'une cellule de mémoire flash à grille divisée sélectionnée pendant une opération d'effacement.
